# EUROPEAN PATENT SPECIFICATION

(11) **EP 3 910 383 B1**
(45) Date of publication and mention of the grant of the patent: **12.11.2025**
(21) Application number: 21171462.1
(22) Date of filing: 30.04.2021
(51) Int. Cl.: G02B 1/08, G02B 5/30, B32B 7/12, H10K 59/80

(54) **OPTICAL FILM AND DISPLAY DEVICE INCLUDING THE SAME**
OPTISCHER FILM UND ANZEIGEVORRICHTUNG DAMIT
FILM OPTIQUE ET AFFICHEUR LE COMPRENANT

(30) Priority: 12.05.2020 KR 20200056350
(43) Date of publication of application: 17.11.2021
(73) Proprietor: Samsung Display Co., Ltd., Yongin-si, Gyeonggi-Do 17113 (KR)
(72) Inventor: BEON, Beong-Hun, Hwaseong-si (KR); LEE, Duk Jin, Suwon-si (KR); JUNG, Woo Suk, Cheonan-si (KR); CHOI, Dong-Wook, Hwaseong-si (KR)
(74) Representative: Marks & Clerk LLP

(56) References cited:
- WO-A1-2015/085751
- WO-A1-2016/080431
- JP-A- 2015 011 059
- KR-B1- 101 936 157
- US-A1- 2016 356 927

## Description

### BACKGROUND

### 1. Technical Field

Embodiments relate to an optical film and a display device including the optical film.

### 2. Description of the Related Art

A light entering into a display panel may be reflected by an electrode, a metallic wiring or the like, and the reflected light may cause deterioration of visibility and contrast of the display device.

In order to reduce the reflected light, the display device may include a polarizer. The polarizer may include a polarizing layer and a phase-retardation layer to convert a linearly polarized light into a circularly polarized light. As a result, the reflected light exiting from the display device may be decreased.

US 2016/356927 A1 relates to a polarizing film, a pressure sensitive adhesive layer for attaching to the polarizing film and an image display device including the polarizing film.

JP 2015/011059 A relates to a polarizing plate and a liquid crystal display device including such a polarizing plate.

### SUMMARY

Embodiments provide an optical film with improved reliability.

Embodiments provide a display device including the optical film.

The invention is defined in the independent claim. Further advantageous embodiments are defined in the dependent claims.

According to embodiments, migration of ions or polar solvent from an optical film including a polarizing layer may be prevented. Thus, damage to a metal pattern or a metallic function layer adjacent to the optical film may be prevented. Thus, reliability of a display device including the optical film may be improved.

### BRIEF DESCRIPTION OF THE DRAWINGS

Aspects of the embodiments of the inventive concept will be more clearly understood from the following detailed description taken in conjunction with the accompanying drawings.
FIG. 1 is a schematic cross-sectional view illustrating a display device according to an embodiment.
FIG. 2 is a schematic cross-sectional view illustrating a panel part of a display device according to an embodiment.
FIG. 3 is a schematic cross-sectional view illustrating an optical film according to an illustrative embodiment that is not part of the present invention.
FIG. 4 is a perspective view illustrating a process of forming an optical film according to an embodiment.
FIG. 5 is a schematic cross-sectional view illustrating a display device according to an embodiment.
FIGS. 6 to 9 are schematic cross-sectional views illustrating optical films according to exemplary embodiments, wherein only the embodiment displayed in FIG. 7 is according to the present invention.
FIG. 10 is a schematic cross-sectional view illustrating a display device according to an embodiment.

### DETAILED DESCRIPTION OF THE EMBODIMENTS

An optical film and a display device according to embodiments of the inventive concept will be described hereinafter with reference to the accompanying drawings, in which some embodiments are shown. Features of the disclosure and methods of accomplishing the same may be understood more readily by reference to the following detailed description of embodiments and the accompanying drawings. However, the disclosure is not limited to the embodiments described below, but may be implemented in various forms.

In the embodiments, terms such as "first" and "second" are used for distinguishing one component from other components, but the components are not limited to these terms. These elements are only used to distinguish one element from another.

In the embodiments, unless clearly used otherwise, expressions in the singular number include a plural meaning.

In the embodiments, terms such as "comprises," "comprising," "includes," "including," "have," "having," "contains," and/or "containing" used herein specify the presence of stated features or elements, but do not preclude the presence or addition of one or more other features or elements.

In the embodiments, when an element such as a film, area or component is referred to as being "on", "above", or "under" another element, it can be directly on, over, or under the other element, or intervening elements may also be present.

For convenience of description, dimensions of components in the drawings may be expanded or reduced. For example, the size and thickness of each component shown in the drawings are arbitrarily shown for convenience of description, and therefore the disclosure is not necessarily limited to those illustrated in the drawings.

In the specification, the phrase "A and/or B" may be understood to mean "A, B, or A and B." The terms "and" and "or" may be used in the conjunctive or disjunctive sense and may be understood to be equivalent to "and/or". Throughout the disclosure, the expression "at least one of A, B, or C" may indicate only A, only B, only C, both A and B, both A and C, both B and C, all of A, B, and C, or variations thereof.

The terms "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 20%, 10%, or 5% of the stated value.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

Hereinafter, embodiments of the disclosure will be described in detail with reference to the accompanying drawings, and the same or corresponding components will be denoted by the same reference numerals.

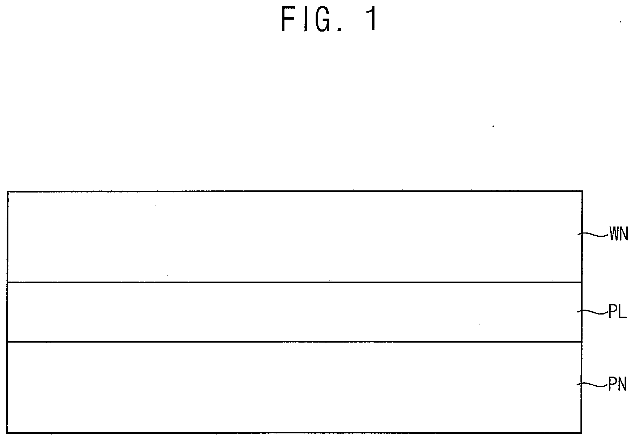

FIG. 1 is a schematic cross-sectional view illustrating a display device according to an embodiment.

Referring to FIG. 1, a display device includes a panel part PN, an optical film PL, and a protective window WN. The optical film PL may be disposed on an upper surface of the panel part PN. For example, the optical film PL may be combined with an upper surface of the panel part PN. The upper surface of the panel part PN may be a light-exiting surface, through which a light generated in the panel part PN may exit outwardly. The protective window WN may be disposed on an upper surface of the optical film PL. For example, the protective window WN may be combined with an upper surface of the optical film PL. Thus, the optical film PL may be disposed between the panel part PN and the protective window WN. The optical film PL may function as a polarizer.

An adhesive layer may be provided between the panel part PN and the optical film PL and between the optical film PL and the protective window WN to combine the panel part PN and the optical film PL with each other and to combine the optical film PL and the protective window WN with each other. For example, the adhesive layer may include an acrylic adhesive or an optically clear adhesive.

For example, the protective window WN may include glass, a polymeric material, or a combination thereof. In an embodiment, the protective window WN may include a glass thin film or a polymeric material having flexibility.

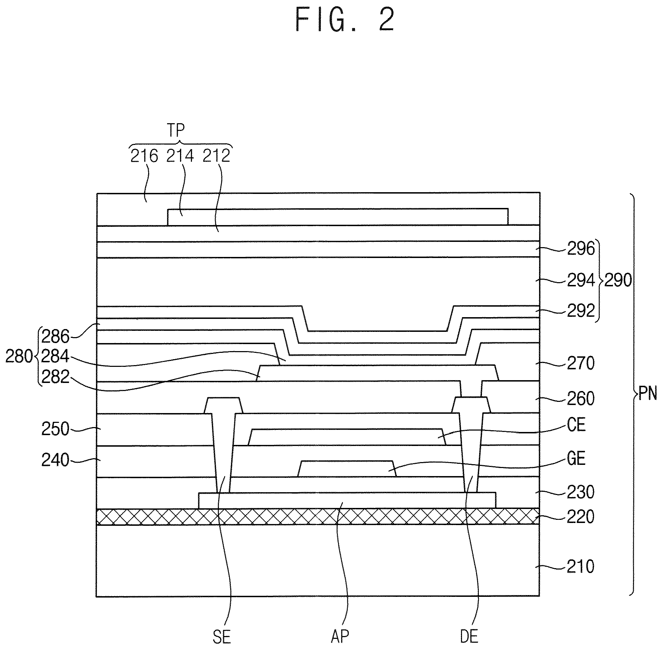

FIG. 2 is a schematic cross-sectional view illustrating a panel part of a display device according to an embodiment. The panel part may include a display panel including a pixel array. In an embodiment, the display panel may include an organic light-emitting display panel.

Referring to FIG. 2, a pixel unit of the panel part PN may include a driving element and a light-emitting element electrically connected to the driving element. In an embodiment, the light-emitting element may be an organic light-emitting diode. The driving element may include at least one thin film transistor.

In an embodiment, a buffer layer 220 may be disposed on a base substrate 210. An active pattern AP may be disposed on the buffer layer 220.

For example, the base substrate 210 may include glass, quartz, sapphire, a polymeric material, or the like. In an embodiment, the base substrate 210 may be a flexible substrate including a polymeric material. For example, the base substrate 210 may include polyethylene naphthalate, polyethylene terephthalate, polyether ketone, polycarbonate, polyarylate, polyether sulphone, polyimide, or a combination thereof.

The panel part PN may further include a supporting substrate disposed under the base substrate 210.

The buffer layer 220 may prevent or reduce permeation of impurities, humidity, or external gas from underneath of the base substrate 210, and may reduce a roughness of an upper surface of the base substrate 210. For example, the buffer layer 220 may include an inorganic material such as oxide, nitride, or the like.

A first gate metal pattern including a gate electrode GE may be disposed on the active pattern AP. A first insulation layer 230 may be disposed between the active pattern AP and the gate electrode GE.

A second gate metal pattern including a capacitor electrode pattern CE may be disposed on the gate electrode GE. The second gate metal pattern may further include a wiring for transferring various signals or the like.

A second insulation layer 240 may be disposed between the gate electrode GE and the capacitor electrode pattern CE. A third insulation layer 250 may be disposed on the capacitor electrode pattern CE.

For example, the active pattern AP may include silicon or a metal oxide semiconductor. In an embodiment, the active pattern AP may include polycrystalline silicon (polysilicon), which may be doped with n-type impurities or p-type impurities.

In another embodiment or in another transistor that is not illustrated, an active pattern may include a metal oxide semiconductor. For example, the active pattern may include a two-component compound (ABₓ), a ternary compound (ABₓC_{y}) or a four-component compound (ABₓC_{y}D_{z}), which may contain indium (In), zinc (Zn), gallium (Ga), tin (Sn), titanium (Ti), aluminium (Al), hafnium (Hf), zirconium (Zr), or magnesium (Mg). For example, the active pattern may include zinc oxide (ZnOₓ), gallium oxide (GaOₓ), titanium oxide (TiOₓ), tin oxide (SnOₓ), indium oxide (InOₓ), indium-gallium oxide (IGO), indium-zinc oxide (IZO), indium tin oxide (ITO), gallium zinc oxide (GZO), zinc magnesium oxide (ZMO), zinc tin oxide (ZTO), zinc zirconium oxide (ZnZrₓO_{y}), indium-gallium-zinc oxide (IGZO), indium-zinc-tin oxide (IZTO), indium-gallium-hafnium oxide (IGHO), tin-aluminium-zinc oxide (TAZO), indium-gallium-tin oxide (IGTO) or the like.

The first insulation layer 230, the second insulation layer 240, and the third insulation layer 250 may each independently include silicon oxide, silicon nitride, silicon oxynitride, silicon carbide, or a combination thereof. The first insulation layer 230, the second insulation layer 240, and the third insulation layer 250 may each include an insulating metal oxide such as aluminium oxide, tantalum oxide, hafnium oxide, zirconium oxide, titanium oxide, or the like. For example, the first insulation layer 230, the second insulation layer 240, and the third insulation layer 250 may each have a single-layered structure or a multi-layered structure including silicon nitride and/or silicon oxide, respectively, or may have different structures from each other.

The gate electrode GE and the capacitor electrode pattern CE may include a metal, a metal alloy, a metal nitride, a conductive metal oxide, or the like. For example, the gate electrode GE and the capacitor electrode pattern CE may each independently include gold (Au), silver (Ag), aluminium (Al), copper (Cu), nickel (Ni), platinum (Pt), magnesium (Mg), chromium (Cr), tungsten (W), molybdenum (Mo), titanium (Ti), tantalum (Ta), or an alloy thereof, and may have a single-layered structure or a multi-layered structure including different metal layers.

A first source metal pattern may be disposed on the third insulation layer 250. The first source metal pattern may include a source pattern SE and a drain pattern DE, which electrically contact the active pattern AP. The source pattern SE and the drain pattern DE may pass through the insulation layers disposed thereunder to contact the active pattern AP, respectively.

The first source metal pattern may include a metal, a metal alloy, a metal nitride, a conductive metal oxide, or the like. For example, the first source metal pattern may include gold (Au), silver (Ag), aluminium (Al), copper (Cu), nickel (Ni), platinum (Pt), magnesium (Mg), chromium (Cr), tungsten (W), molybdenum (Mo), titanium (Ti), tantalum (Ta), or an alloy thereof, and may have a single-layered structure or a multi-layered structure including different metal layers. In an embodiment, the first source metal pattern may have a multi-layered structure including an aluminium layer.

A fourth insulation layer 260 may be disposed on the first source metal pattern. The fourth insulation layer 260 may include an organic material. For example, the fourth insulation layer 260 may include an organic insulation material such as a phenol resin, an acryl resin, a polyimide resin, a polyamide resin, a siloxane resin, an epoxy resin, or the like.

An organic light-emitting diode 280 may be disposed on the fourth insulation layer 260. The organic light-emitting diode 280 may include a first electrode 282 electrically contacting the drain pattern DE, an organic light-emitting layer 284 disposed on the first electrode 282, and a second electrode 286 disposed on the organic light-emitting layer 284. The organic light-emitting layer 284 of the organic light-emitting diode 280 may be disposed at least in an opening of a pixel-defining layer 270 disposed on the fourth insulation layer 260. The first electrode 282 may be a lower electrode of the organic light-emitting diode 280, and the second electrode 286 may be an upper electrode of the organic light-emitting diode 280.

The first electrode 282 may function as an anode. For example, the first electrode 282 may be formed as a transmissive electrode or a reflecting electrode according to an emission type of the display device. When the first electrode 282 is a transmissive electrode, the first electrode 282 may include indium tin oxide, indium zinc oxide, zinc tin oxide, indium oxide, zinc oxide, tin oxide, or the like. When the first electrode 282 is a reflecting electrode, the first electrode 282 may include gold (Au), silver (Ag), aluminium (Al), copper (Cu), nickel (Ni), platinum (Pt), magnesium (Mg), chromium (Cr), tungsten (W), molybdenum (Mo), titanium (Ti), or a combination thereof, and may have a stacked structure further including the material that may be used for the transmissive electrode.

The pixel-defining layer 270 may have the opening overlapping at least a portion of the first electrode 282. For example, the pixel-defining layer 270 may include an organic insulating material.

The organic light-emitting layer 284 may include at least a light-emitting layer, and may further include at least one of a hole injection layer (HIL), a hole transporting layer (HTL), an electron transporting layer (ETL), and an electron injection layer (EIL). For example, the organic light-emitting layer 284 may include a low molecular weight organic compound or a high molecular weight organic compound.

In an embodiment, the organic light-emitting layer 284 may emit a red light, a green light, or a blue light. In another embodiment, the organic light-emitting layer 284 may emit a white light. The organic light-emitting layer 284 emitting a white light may have a multi-layer structure including a red-emitting layer, a green-emitting layer, and a blue-emitting layer, or it may have a single-layer structure including a mixture of a red-emitting material, a green-emitting material, and a blue-emitting material.

The second electrode 286 may be formed as a transmissive electrode or a reflecting electrode according to an emission type of the display device. For example, the second electrode 286 may include a metal, a metal alloy, a metal nitride, a metal fluoride, a conductive metal oxide, or a combination thereof.

For example, the second electrode 286 and at least one layer of the organic light-emitting layer 284 may be formed as a common layer extending continuously over pixels in a display area. However, embodiments are not limited thereto. For example, the organic light-emitting layer 284 may be formed as patterns corresponding to a pixel area and separated from each other.

An encapsulation layer 290 may be disposed on the organic light-emitting diode 280. The encapsulation layer 290 may have a stacked structure of an inorganic thin film and an organic thin film. For example, the encapsulation layer 290 may include a first inorganic thin film 292, an organic thin film 294 disposed on the first inorganic thin film 292 and a second inorganic thin film 296 disposed on the organic thin film 294. However, embodiments are not limited thereto. For example, the encapsulation layer 290 may include at least two organic thin films and at least three inorganic thin films.

A touch-sensing part TP may be disposed on the encapsulation layer 290. For example, the touch-sensing part TP may sense an external input by detecting a variation of a capacitance, thereby obtaining coordinate information of the external input. However, embodiments are not limited thereto. A touch-sensing part may sense an external input by detecting a pressure.

For example, the touch-sensing part TP may include a lower touch insulation layer 212, a sensing conductive pattern 214 and a protective layer 216.

The sensing conductive pattern 214 may include first sensing electrodes, which are arranged in a first direction, and second sensing electrodes, which are arranged in a second direction perpendicular to the first direction. For example, the first sensing electrodes may be electrically connected to each other by a connection portion disposed in a same layer as the first sensing electrodes. The second sensing electrodes may be electrically connected to each other by a bridge pattern disposed in a different layer from the second sensing electrodes.

The lower touch insulation layer 212 and the protective layer 216 may each independently include an inorganic insulating material. For example, the lower touch insulation layer 212 and the protective layer 216 may each independently include silicon oxide, silicon nitride, silicon oxynitride, silicon carbide, or a combination thereof. The lower touch insulation layer 212 and the protective layer 216 may each independently include an insulating metal oxide such as aluminium oxide, tantalum oxide, hafnium oxide, zirconium oxide, titanium oxide, or the like.

The sensing conductive pattern 214 may include a conductive material. For example, the sensing conductive pattern 214 may include a metal, a conductive metal oxide, a conductive polymer, graphene, carbon nano tube, or a combination thereof. For example, the metal may include molybdenum, silver, titanium, copper, aluminium, or an alloy thereof. For example, the metal may be provided to have a shape of a continuous thin film or a nano wire. For example, the conductive metal oxide may include indium tin oxide, indium zinc oxide, zinc tin oxide, indium oxide, zinc oxide, tin oxide, or a combination thereof. The sensing conductive pattern 214 may have a single-layer structure or a multi-layered structure including different materials.

The bridge pattern may include a same material as or a different material from the sensing conductive pattern 214.

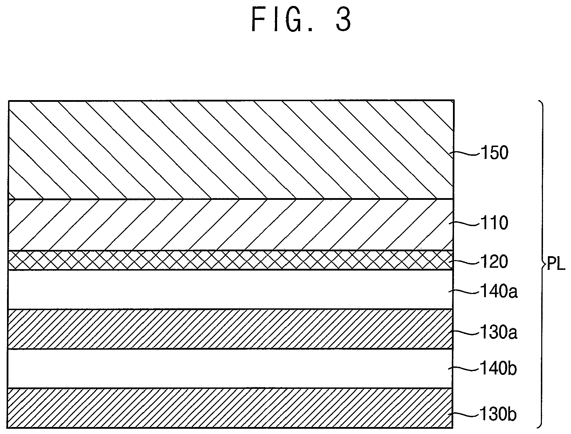

FIG. 3 is a schematic cross-sectional view illustrating an optical film according to an embodiment.

Referring to FIG. 3, the optical film PL according to an illustrative embodiment, that is not part of the present invention, may include a polarizing layer 110, a protective layer 150, an inorganic barrier layer 120, a first phase-retardation layer 130a, a second phase-retardation layer 130b, a first adhesive layer 140a and a second adhesive layer 140b.

The polarizing layer 110 may function as a polarizer, which converts an incident light into a linearly polarized light. The polarizing layer 110 includes a polymer dyed with iodine. For example, the polarizing layer 110 may be obtained from dyeing a polymer film including polyvinyl alcohol (PVA) or the like, for example, with iodine, and stretching (e.g., drawing) the dyed film. In an embodiment, the polarizing layer 110 may further include boric acid, moisture, or the like.

The first phase-retardation layer 130a and the second phase-retardation layer 130b may each function as a circular polarizer, which converts the linearly polarized light into a circularly polarized light (including an elliptic polarized light). For example, the first phase-retardation layer 130a and the second phase-retardation layer 130b may each independently function as a half-wave plate or as a quarter-wave plate.

In an embodiment, at least one of the first phase-retardation layer 130a and the second phase-retardation layer 130b may each independently include cyclo-olefin polymer, polyacrylate, polycarbonate (PC), polystyrene (PSt), polyethylene terephthalate (PET), cellulose-based polymer, liquid crystal molecule, or a combination thereof. For example, the first phase-retardation layer 130a may include cyclo-olefin polymer, and the second phase-retardation layer 130b may include polyacrylate. In another embodiment, the first and second phase-retardation layers 130a and 130b may include the same material.

For example, the first phase-retardation layer 130a may include a positively birefringent material that has a slow axis representing a maximum refractive coefficient in a stretching direction. For example, the first phase-retardation layer 130a may include at least one of a cyclo-olefin polymer, PC, PET, and a cellulose-based polymer. In an embodiment, an unstretched film including a positively birefringent material may be prepared and rolled to form a rolled film. The rolled film may be unrolled and proceeded. The proceeded film may be stretched substantially in a direction oblique to a proceeding direction, and may be rolled again to form a roll of the first phase-retardation layer 130a having an oblique slow axis (optical axis).

For example, the second phase-retardation layer 130b may include a negatively birefringent material that has a slow axis representing a maximum refractive coefficient in a direction substantially perpendicular to a stretching direction. For example, the second phase-retardation layer 130b may include at least one of PSt, polyacrylate, PC, and acrylate-styrene copolymer. In an embodiment, an unstretched film including a negatively birefringent material may be prepared and rolled to form a rolled film. The rolled film may be unrolled and proceeded. The proceeded film may be stretched in a direction substantially perpendicular to a proceeding direction, and may be rolled again to form a roll of the second phase-retardation layer 130b having a slow axis substantially parallel to the proceeding direction of the proceeded film.

The protective layer 150 may be disposed on the polarizing layer 110 to protect the polarizing layer 110.

For example, the protective layer 150 may include polymethylmethacrylate (PMMA), triacetylcellulose (TAC), cyclo-olefin polymer, PET, or a combination thereof. In an embodiment, the protective layer 150 may include TAC.

The first adhesive layer 140a may combine the first phase-retardation layer 130a with the polarizing layer 110. The second adhesive layer 140b may combine the first phase-retardation layer 130a with the second phase-retardation layer 130b. For example, the first adhesive layer 140a may be disposed between the inorganic barrier layer 120, which may be directly disposed on a surface of the polarizing layer 110, and the first phase-retardation layer 130a. For example, the inorganic barrier layer 120 may be directly combined with a surface of the polarizing layer 110 and the first phase-retardation layer 130a.

For example, the first adhesive layer 140a and the second adhesive layer 140b may each independently include an acrylic adhesive, a UV glue, a PVA-based adhesive, or the like. In an embodiment, the first adhesive layer 140a and the second adhesive layer 140b may each include a UV glue. The first and second adhesive layers 140a and 140b formed from the UV glue may have a smaller thickness and a greater durability against an external force such as a bending force.

In an embodiment, the first adhesive layer 140a may include a silane coupling agent and an adhesive binder to increase adhesion to the inorganic barrier layer 120.

The inorganic barrier layer 120 may block migration of ions from the polarizing layer 110.

According to the invention, the inorganic barrier layer 120 includes a non-polar inorganic material. For example, the inorganic barrier layer 120 may include NaF, Na₃AlF₃, LiF, MgF₂, CaF₂, BaF₂, SiO₂, LaF₃, CeF, Al₂O₃, ZrOₓ (zirconium oxide), NbOₓ (niobium oxide), ATO (antimony tin oxide), SiNₓ (silicon nitride), or a combination thereof.

The inorganic barrier layer 120 may include a material, which has no birefringence, has a refractivity of about 1.5, has a light-transmittance greater than or equal to about 90%, and has a water vapor transmission rate (WVTR) equal to or less than about 100g/day·m². For example, the WVTR may be measured according to ASTM F 1249. In view of the above, the inorganic barrier layer 120 may include, for example, SiO₂.

A thickness of the inorganic barrier layer 120 is equal to or less than about 5 µm, and a high thickness uniformity may be a desired quality, in order to prevent or reduce interference pattern. For example, a thickness of the inorganic barrier layer 120 may be in a range of about 0.1 µm to about 5 µm.

Iodine ions in the polarizing layer 110 may be dissolved by water, which is a polar solvent, under a condition with a high humidity. When iodine ions enter the panel part PN, a conductive pattern of the touch-sensing part TP may be corroded, thereby deteriorating reliability of the touch-sensing part.

The inorganic barrier layer 120 may block migration of the polar solvent or the ions dissolved by the polar solvent. Thus, iodine ions exiting from the polarizing layer 110 may be prevented from damaging a metal pattern of the panel part PN or the like.

In an embodiment, the inorganic barrier layer 120 may be formed by deposition. The inorganic barrier layer 120 may be formed directly on a surface of the polarizing layer 110 as illustrated in FIG. 3. Since a deposition process for forming the inorganic barrier layer 120 may be performed at a high temperature, the inorganic barrier layer 120 may contract as cooled. The optical film PL including the inorganic barrier layer 120 formed directly on the polarizing layer 110 may have increased reliability when compared to an optical film including an inorganic barrier layer formed directly on the first and second phase-retardation layers 130a and 130b. Thus, cracking of the inorganic barrier layer 120 may be reduced or prevented, and reliability of the polarizing film PL may be improved.

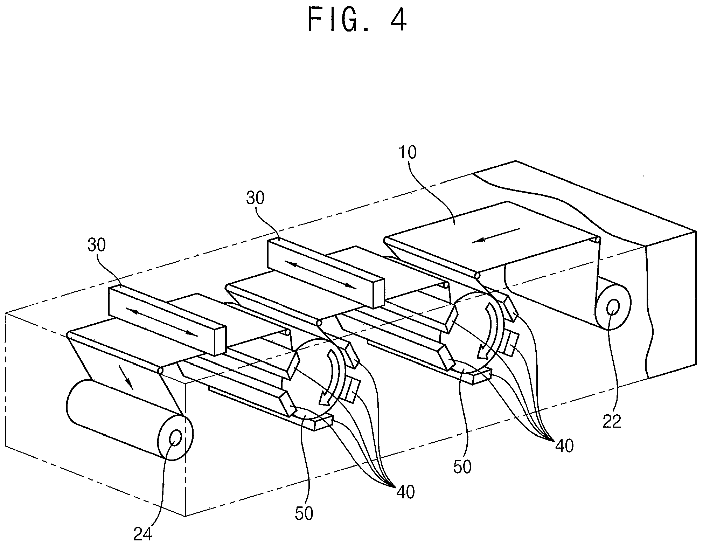

FIG. 4 is a perspective view illustrating a process of forming an optical film according to an embodiment.

An optical film according to an embodiment of the present invention includes an inorganic barrier layer disposed on a polarizing layer. For example, the inorganic barrier layer may be combined with the polarizing layer. FIG. 4 may illustrate a process of forming the inorganic barrier layer on the polarizing layer.

In an embodiment, a roll-to-roll deposition apparatus may be used for forming the inorganic barrier layer on the polarizing layer.

In an embodiment, the roll-to-roll deposition apparatus may include a film-providing roller 22, a cooling drum 50, a deposition part 40, an inspection part 30 and a winding roller 24.

The film-providing roller 22 may provide a film 10. For example, the film 10 may be a polarizing layer. In another embodiment, the film 10 may include a polarizing layer and a protective layer disposed on the polarizing layer. For example, the film 10 may include a protective layer combined with a polarizing layer. In another embodiment, the film 10 may include a phase-retardation layer.

The cooling drum 50 may cool the film 10 to prevent the film 10 from being damaged by heat applied thereto in a deposition process. A cooling agent or the like may be provided to the cooling drum 50 so that the cooling drum 50 may cool the film 10. The cooling drum 50 may function as a stage supporting the film 10 in the deposition process.

The film 10 may be transported along a surface of the cooling drum 50, which may be an outer circumferential surface. The deposition part 40 may be disposed above the surface of the cooling drum 50. For example, deposition parts 40 may be disposed along the surface of the cooling drum 50. The film 10 may be disposed between the cooling drum 50 and the deposition part 40. The film 10 may contact the surface of the cooling drum 50, and may be transported by rotation of the cooling drum 50.

The deposition part 40 may provide a deposition source to the film 10 through sputtering, chemical vaporization deposition, or the like. As a result, the inorganic barrier layer may be formed on a surface of the film 10. In an embodiment, the deposition parts 40 may provide the same deposition source. In another embodiment, the deposition parts 40 may provide different deposition sources depending on a composition of the inorganic barrier layer.

A combination of the deposition part 40 and the cooling drum 50 may be suitably repeated depending on a desired thickness of the inorganic barrier layer.

The inspection part 30 may inspect defects of the inorganic barrier layer, or may measure a thickness of the inorganic barrier layer. Based on results of the inspection, a deposition condition may be adjusted, or products with defects may be identified.

The winding roller 24 may wind the film 10 with the inorganic barrier layer to form a film roll.

In an embodiment, the film 10 may be a polarizing layer. The polarizing layer disposed on the inorganic barrier layer may be disposed on a phase-retardation layer by an adhesive layer to form an optical film. For example, an optical film may be formed from a polarizing layer that is combined with an inorganic barrier layer and with a phase-retardation layer.

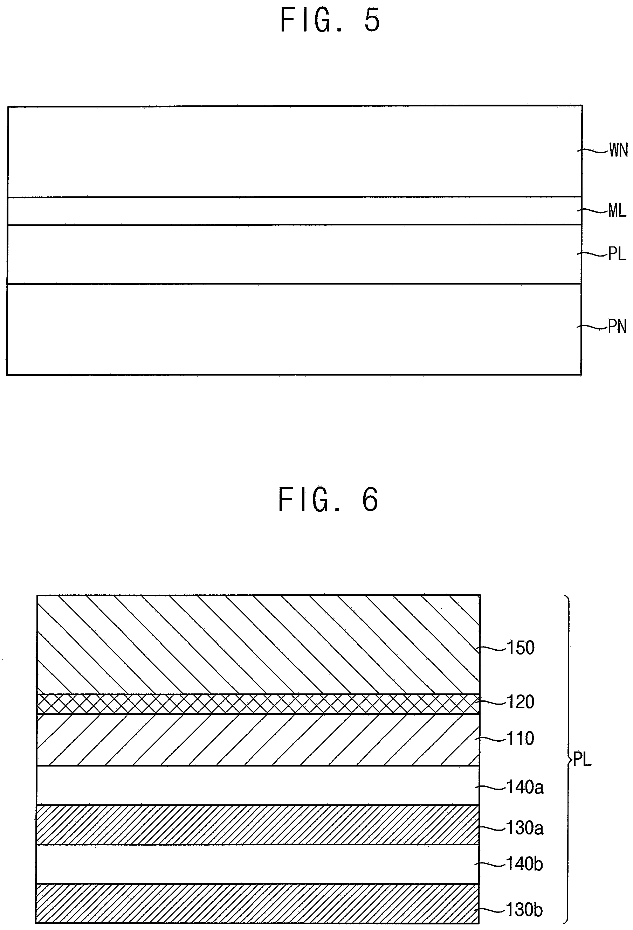

FIG. 5 is a schematic cross-sectional view illustrating a display device according to an embodiment.

Referring to FIG. 5, a display device may include a panel part PN, an optical film PL, a metallic functional layer ML and a protective window WN. The optical film PL may be disposed on an upper surface of the panel part PN. For example, the optical film PL may be combined with an upper surface of the panel part PN. The optical film PL may function as a polarizer.

The metallic functional layer ML may be disposed between the protective window WN and the optical film PL.

The metallic functional layer ML may include at least a metal layer. For example, the metallic functional layer ML may include a metal layer and an inorganic layer, may include a metal layer and an organic layer, or may include a metal layer, an inorganic layer, and an organic layer. In an embodiment, the metallic functional layer ML may include at least one of a fingerprint-sensing part, a pressure-sensing part, and an antenna.

As illustrated in FIG. 5, when the metallic functional layer ML is disposed on the optical film PL, the optical film PL may have a suitable configuration to prevent an ion or a polar solvent in the optical film PL from entering the metallic functional layer ML. For example, the embodiments may be explained with reference to embodiments illustrated in FIGS. 6 to 8.

Referring to FIG. 6, an optical film PL according to an illustrative embodiment, that is not part of the present invention, may include a polarizing layer 110, a protective layer 150, an inorganic barrier layer 120, a first phase-retardation layer 130a, a second phase-retardation layer 130b, a first adhesive layer 140a, and a second adhesive layer 140b.

In the illustrative embodiment, the inorganic barrier layer 120 may be disposed on an upper surface of the polarizing layer 110. For example, the inorganic barrier layer 120 may be combined with an upper surface of the polarizing layer 110. Thus, the inorganic barrier layer 120 may be disposed between the polarizing layer 110 and the protective layer 150. The optical film PL may prevent an ion or a polar solvent in the optical film PL from entering the metallic functional layer disposed on the optical film PL.

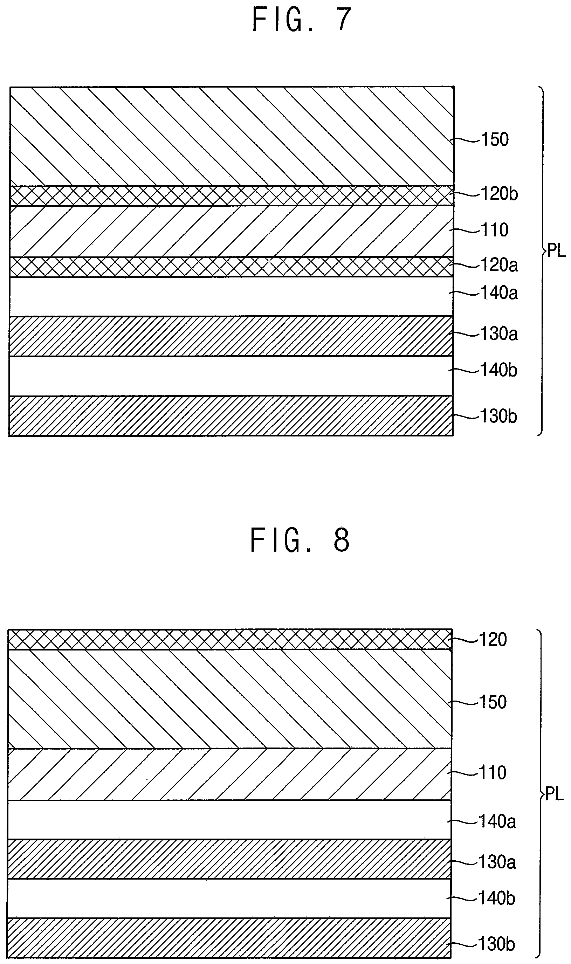

Referring to FIG. 7, an optical film PL according to an embodiment of the present invention, includes a polarizing layer 110, a protective layer 150, a first inorganic barrier layer 120a, a second inorganic barrier layer 120b, a first phase-retardation layer 130a, a second phase-retardation layer 130b, a first adhesive layer 140a, and a second adhesive layer 140b.

The first inorganic barrier layer 120a is disposed on a lower surface of the polarizing layer 110. For example, the first inorganic barrier layer 120a may be combined with a lower surface of the polarizing layer 110. The second inorganic barrier layer 120b is disposed on an upper surface of the polarizing layer 110. For example, the second inorganic barrier layer 120b may be combined with an upper surface of the polarizing layer 110. Thus, the first inorganic barrier layer 120a is disposed between the polarizing layer 110 and the first adhesive layer 140a, and the second inorganic barrier layer 120b is disposed between the polarizing layer 110 and the protective layer 150.

The first and second inorganic barrier layers 120a and 120b may each prevent an ion or a polar solvent in the optical film PL from migrating in both directions.

Referring to FIG. 8, an optical film PL according to another illustrative embodiment, that is not part of the present invention, may include a polarizing layer 110, a protective layer 150, an inorganic barrier layer 120, a first phase-retardation layer 130a, a second phase-retardation layer 130b, a first adhesive layer 140a and a second adhesive layer 140b.

In the illustrative embodiment, the protective layer 150 is disposed on the polarizing layer 110, and the inorganic barrier layer 120 is disposed on the protective layer 150. Thus, the optical film PL may prevent an ion or a polar solvent in the optical film PL from entering the metallic functional layer ML disposed on the optical film PL.

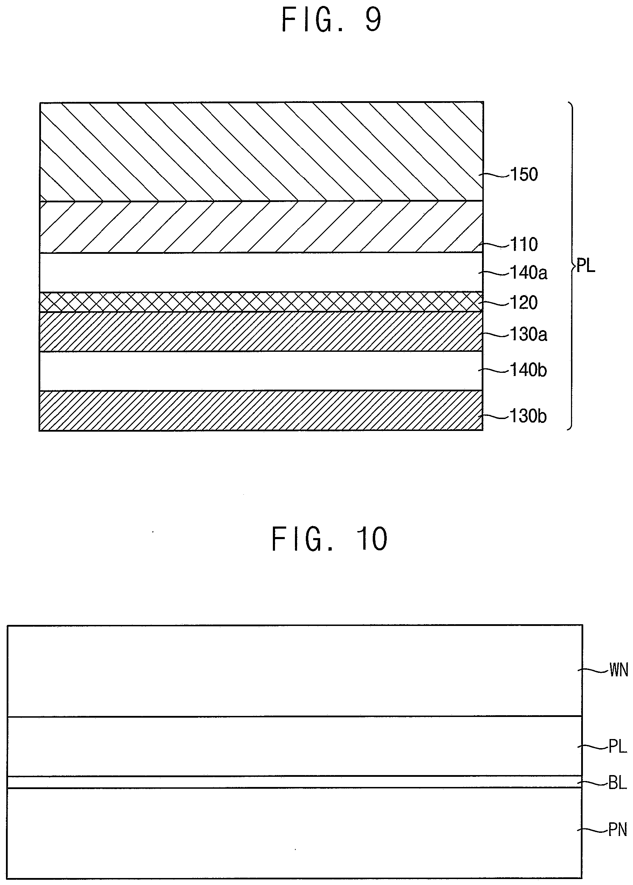

FIG. 9 is a schematic cross-sectional view illustrating an optical film according to another illustrative embodiment that does not form part of the present invention.

Referring to FIG. 9, an optical film PL according to this illustrative embodiment may include a polarizing layer 110, a protective layer 150, an inorganic barrier layer 120, a first phase-retardation layer 130a, a second phase-retardation layer 130b, a first adhesive layer 140a, and a second adhesive layer 140b.

In an embodiment, the inorganic barrier layer 120 may be disposed on at least one of the first and second phase-retardation layers 130a and 130b. For example, the inorganic barrier layer 120 may be disposed on the first phase-retardation layer 130a so that it may be disposed between the first phase-retardation layer 130a and the first adhesive layer 140a. For example, the inorganic barrier layer 120 may be combined with the first phase-retardation layer 130a.

For example, the inorganic barrier layer 120 may be formed by depositing an inorganic material on a film, which includes the first phase-retardation layer 130a, as illustrated in FIG. 4.

FIG. 10 is a schematic cross-sectional view illustrating a display device according to an embodiment.

Referring to FIG. 10, a display device includes a panel part PN, an optical film PL, and a protective window WN. The optical film PL may be disposed on an upper surface of the panel part PN. The upper surface of the panel part PN may be a light-exiting surface, through which a light generated in the panel part PN may exit outwardly. The protective window WN may be disposed on an upper surface of the optical film PL. For example, the protective window WN may be combined with an upper surface of the optical film PL. Thus, the optical film PL may be disposed between the panel part PN and the protective window WN.

The optical film PL includes a polarizing layer functioning as a polarizer. In an illustrative example, not according to the invention, the optical film PL may include a polarizing layer, a protective layer disposed on an upper surface of the polarizing layer, and at least one phase-retardation layer disposed on a lower surface of the polarizing layer. For example, in the optical film PL, the protective layer may be combined with an upper surface of the polarizing layer and the at least one phase-retardation layer may be combined with a lower surface of the polarizing layer. For example, the panel part PN may include a touch-sensing part as illustrated in FIG. 2.

The display device may include an inorganic barrier layer BL disposed between the optical film PL and the panel part PN. Thus, the inorganic barrier layer BL may be disposed between the polarizing layer of the optical film PL and the touch-sensing part of the panel part PN. For example, the inorganic barrier layer BL may be deposited on a lower surface of the optical film PL or on an upper surface of the touch-sensing part.

The inorganic barrier layer BL may prevent an ion or a polar solvent in the optical film PL from entering the touch-sensing part of the panel part PN.

The above embodiments provide an organic-light emitting display device. However, embodiments are not limited thereto. For example, embodiments may be applied for various display devices such as a liquid crystal display device, an electroluminescent display device, a micro LED display device, or the like.

Embodiments may be applied to various display devices. In an embodiment, for example, embodiments may be applied to vehicle-display device, a ship-display device, an aircraft-display device, portable communication devices, display devices for display or for information transfer, a medical-display device, etc.

The foregoing is illustrative of embodiments and is not to be construed as limiting thereof. Although embodiments have been described, those skilled in the art will readily appreciate that many modifications are possible in the embodiments without departing from the scope of the appended claims.

## Claims

1. An optical film (PL) comprising:
a polarizing layer (110) including a polymer dyed with iodine;
a phase-retardation layer (130a, 130b) disposed under the polarizing layer (110);
an inorganic barrier layer (120) including a non-polar inorganic material; and
a protective layer (150), wherein
the inorganic barrier layer (120) is disposed on at least a surface of the polarizing layer (110),
the inorganic barrier layer (120) has a water vapor transmission rate (WVTR) equal to or less than about 100g/day·m² measured according to ASTM F 1249, and
the inorganic barrier layer (120) has a thickness equal to or less than about 5 µm,
**characterized in that** the inorganic barrier layer (120) includes:
a first inorganic barrier layer (120a) disposed between the polarizing layer (110) and the phase-retardation layer (130a, 130b); and
a second inorganic barrier layer (120b) disposed between the polarizing layer (110) and the protective layer (150).

2. An optical film (PL) according to claim 1, wherein the inorganic barrier layer (120) includes at least one of NaF, Na₃AlF₃, LiF, MgF₂, CaF₂, BaF₂, SiO₂, LaF₃, CeF, Al₂O₃, ZrOₓ (zirconium oxide), NbOₓ (niobium oxide), ATO (antimony tin oxide), and SiNₓ (silicon nitride).

3. An optical film (PL) according to claim 1 or claim 2, wherein the inorganic barrier layer (120) includes SiO₂.

4. An optical film (PL) according to any one of claims 1 to 3, wherein the protective layer (150) includes at least one of polymethylmethacrylate, triacetylcellulose, cyclo-olefin polymer, and polyethylene terephthalate.

5. An optical film (PL) according to any one of claims 1 to 4, further comprising an adhesive layer (140a) contacting the inorganic barrier layer (120), the adhesive layer (140a) including an adhesive binder and a silane coupling agent.

6. An optical film (PL) according to any one of claims 1 to 5, wherein the phase retardation layer (130a, 130b) includes:
a first phase-retardation layer (130a) that is a half wave plate; and
a second phase-retardation layer (130b) that is a quarter wave plate.

7. A display device comprising:
a panel part (PN) including a display panel; and
an optical film (PL) according to claim 1 disposed on at least a surface of the panel part (PN).

8. A display device according to claim 7, wherein the inorganic barrier layer (120) includes at least one of NaF, Na₃AlF₃, LiF, MgF₂, CaF₂, BaF₂, SiO₂, LaF₃, CeF, Al₂O₃, ZrOₓ (zirconium oxide), NbOₓ (niobium oxide), ATO (antimony tin oxide), and SiNₓ (silicon nitride).

9. A display device according to claim 7 or claim 8, wherein the inorganic barrier layer (120) includes SiO₂.

10. A display device according to any one of claims 7 to 9, wherein
the protective layer (150) is disposed on the polarizing layer (110) and includes at least one of polymethylmethacrylate, triacetylcellulose, cyclo-olefin polymer, and polyethylene terephthalate.

11. A display device according to any one of claims 7 to 10, wherein the inorganic barrier layer (120) is directly disposed on the polarizing layer (110).

## Patentansprüche

1. Optischer Film (PL), umfassend:
eine Polarisationsschicht (110), die ein mit Jod gefärbtes Polymer beinhaltet;
eine Phasenverzögerungsschicht (130a, 130b), die unter der Polarisationsschicht (110) angeordnet ist;
eine anorganische Barriereschicht (120), die ein nicht-polares anorganisches Material beinhaltet; und
eine Schutzschicht (150), wobei
die anorganische Barriereschicht (120) auf mindestens einer Oberfläche der Polarisationsschicht (110) angeordnet ist,
die anorganische Barriereschicht (120) eine Wasserdampfdurchlässigkeitsrate (WVTR) gleich oder kleiner als etwa 100g/Tag m², gemäß ASTM F 1249 gemessen aufweist, und
die anorganische Barriereschicht (120) eine Dicke gleich oder kleiner als etwa 5 µm aufweist,
**dadurch gekennzeichnet, dass** die anorganische Barriereschicht (120) beinhaltet:
eine erste anorganische Barriereschicht (120a), die zwischen der Polarisationsschicht (110) und der Phasenverzögerungsschicht (130a, 130b) angeordnet ist; und
eine zweite anorganische Barriereschicht (120b), die zwischen der Polarisationsschicht (110) und der Schutzschicht (150) angeordnet ist.

2. Optischer Film (PL) nach Anspruch 1, wobei die anorganische Barriereschicht (120) mindestens eines von NaF, Na₃AlF₃, LiF, MgF₂, CaF₂, BaF₂, SiO₂, LaF₃, CeF, Al₂O₃, ZrOₓ (Zirkoniumoxid), NbOₓ (Nioboxid), ATO (Antimonzinnoxid) und SiNₓ (Siliziumnitrid) beinhaltet.

3. Optischer Film (PL) nach Anspruch 1 oder Anspruch 2, wobei die anorganische Barriereschicht (120) SiO₂ beinhaltet.

4. Optischer Film (PL) nach einem der Ansprüche 1 bis 3, wobei die Schutzschicht (150) mindestens eines von Polymethylmethacrylat, Triacetylcellulose, Cycloolefinpolymer und Polyethylenterephthalat beinhaltet.

5. Optischer Film (PL) nach einem der Ansprüche 1 bis 4, der weiter eine Klebstoffschicht (140a) umfasst, die mit der anorganischen Barriereschicht (120) in Kontakt steht, wobei die Klebstoffschicht (140a) ein Klebebindemittel und ein Silankopplungsmittel beinhaltet.

6. Optischer Film (PL) nach einem der Ansprüche 1 bis 5, wobei die Phasenverzögerungsschicht (130a, 130b) beinhaltet:
eine erste Phasenverzögerungsschicht (130a), die eine Halbwellenplatte ist; und
eine zweite Phasenverzögerungsschicht (130b), die eine Viertelwellenplatte ist.

7. Anzeigevorrichtung, umfassend:
ein Tafelteil (PN), das eine Anzeigetafel beinhaltet; und
einen optischen Film (PL) nach Anspruch 1, der auf mindestens einer Oberfläche des Tafelteils (PN) angeordnet ist.

8. Anzeigevorrichtung nach Anspruch 7, wobei die anorganische Barriereschicht (120) mindestens eines von NaF, Na₃AlF₃, LiF, MgF₂, CaF₂, BaF₂, SiO₂, LaF₃, CeF, Al₂O₃, ZrOₓ (Zirkoniumoxid), NbOₓ (Nioboxid), ATO (Antimonzinnoxid) und SiNₓ (Siliziumnitrid) beinhaltet.

9. Anzeigevorrichtung nach Anspruch 7 oder Anspruch 8, wobei die anorganische Barriereschicht (120) SiO₂ beinhaltet.

10. Anzeigevorrichtung nach einem der Ansprüche 7 bis 9, wobei
die Schutzschicht (150) auf der Polarisationsschicht (110) angeordnet ist und mindestens eines von Polymethylmethacrylat, Triacetylcellulose, Cycloolefinpolymer und Polyethylenterephthalat beinhaltet.

11. Anzeigevorrichtung nach einem der Ansprüche 7 bis 10, wobei die anorganische Barriereschicht (120) direkt auf der Polarisationsschicht (110) angeordnet ist.

## Revendications

1. Film optique (PL) comprenant :
une couche polarisante (110) incluant un polymère teinté à l'iode ;
une couche de retard de phase (130a, 130b) disposée sous la couche polarisante (110) ;
une couche barrière inorganique (120) incluant un matériau inorganique non polaire ; et
une couche protectrice (150), dans lequel
la couche barrière inorganique (120) est disposée sur au moins une surface de la couche polarisante (110),
la couche barrière inorganique (120) présente un taux de transmission de vapeur d'eau (WVTR) égal ou inférieur à environ 100 g/jour·m² mesuré selon la norme ASTM F 1249, et
la couche barrière inorganique (120) présente une épaisseur égale ou inférieure à environ 5 µm,
**caractérisé en ce que** la couche barrière inorganique (120) inclut :
une première couche barrière inorganique (120a) disposée entre la couche polarisante (110) et la couche de retard de phase (130a, 130b) ; et
une seconde couche barrière inorganique (120b) disposée entre la couche polarisante (110) et la couche protectrice (150).

2. Film optique (PL) selon la revendication 1, dans lequel la couche barrière inorganique (120) inclut au moins l'un parmi NaF, Na₃AlF₃, LiF, MgF₂, CaF₂, BaF₂, SiO₂, LaF₃, CeF, Al₂O₃, ZrOₓ (oxyde de zirconium), NbOₓ (oxyde de niobium), ATO (oxyde d'antimoine et d'étain) et SiNₓ (nitrure de silicium).

3. Film optique (PL) selon la revendication 1 ou la revendication 2, dans lequel la couche barrière inorganique (120) inclut du SiO₂.

4. Film optique (PL) selon l'une quelconque des revendications 1 à 3, dans lequel la couche protectrice (150) inclut au moins un élément parmi le polyméthacrylate de méthyle, la triacétylcellulose, le polymère de cyclooléfine et le polyéthylène téréphtalate.

5. Film optique (PL) selon l'une quelconque des revendications 1 à 4, comprenant en outre une couche adhésive (140a) en contact avec la couche barrière inorganique (120), la couche adhésive (140a) incluant un liant adhésif et un agent de couplage au silane.

6. Film optique (PL) selon l'une quelconque des revendications 1 à 5, dans lequel la couche de retard de phase (130a, 130b) inclut :
une première couche de retard de phase (130a) qui est une lame demi-onde ; et
une seconde couche de retard de phase (130b) qui est une lame quart d'onde.

7. Afficheur comprenant :
une partie de panneau (PN) incluant un panneau d'affichage ; et
un film optique (PL) selon la revendication 1 disposé sur au moins une surface de la partie de panneau (PN).

8. Afficheur selon la revendication 7, dans lequel la couche barrière inorganique (120) inclut au moins l'un parmi NaF, Na₃AlF₃, LiF, MgF₂, CaF₂, BaF₂, SiO₂, LaF₃, CeF, Al₂O₃, ZrOₓ (oxyde de zirconium), NbOₓ (oxyde de niobium), ATO (oxyde d'antimoine et d'étain) et SiNₓ (nitrure de silicium).

9. Afficheur selon la revendication 7 ou la revendication 8, dans lequel la couche barrière inorganique (120) inclut du SiO₂.

10. Afficheur selon l'une quelconque des revendications 7 à 9, dans lequel
la couche protectrice (150) est disposée sur la couche polarisante (110) et inclut au moins un élément parmi le polyméthacrylate de méthyle, la triacétylcellulose, le polymère de cyclooléfine et le polyéthylène téréphtalate.

11. Afficheur selon l'une quelconque des revendications 7 à 10, dans lequel la couche barrière inorganique (120) est directement disposée sur la couche polarisante (110).
